(19) Europäisches Patentamt
European Patent Office
Office européen des brevets

(11) **EP 3 053 202 B1**

(12) **FASCICULE DE BREVET EUROPEEN**

(45) Date de publication et mention
de la délivrance du brevet:
**13.10.2021 Bulletin 2021/41**

(21) Numéro de dépôt: **14777597.7**

(22) Date de dépôt: **30.09.2014**

(51) Int Cl.:
*H01L 39/22* *(2006.01)*  *H01L 39/24* *(2006.01)*

(86) Numéro de dépôt international:
**PCT/EP2014/070905**

(87) Numéro de publication internationale:
**WO 2015/049224 (09.04.2015 Gazette 2015/14)**

(54) **PROCÉDÉ DE FABRICATION D'UNE JONCTION JOSEPHSON ET JONCTION JOSEPHSON ASSOCIÉE**

VERFAHREN ZUR HERSTELLUNG EINES JOSEPHSON-ÜBERGANGS UND ZUGEHÖRIGER JOSEPHSON-ÜBERGANG

PROCESS FOR MANUFACTURING A JOSEPHSON JUNCTION AND ASSOCIATED JOSEPHSON JUNCTION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.10.2013 FR 1302280**

(43) Date de publication de la demande:
**10.08.2016 Bulletin 2016/32**

(73) Titulaire: **Thales**
**92200 Neuilly Sur Seine (FR)**

(72) Inventeurs:
• **CRETE, Denis**
  **91767 Palaiseau (FR)**

• **MARCILHAC, Bruno**
  **91767 Palaiseau (FR)**
• **LEMAÎTRE, Yves**
  **91767 Palaiseau (FR)**

(74) Mandataire: **Lavoix**
**2, place d'Estienne d'Orves**
**75441 Paris Cedex 09 (FR)**

(56) Documents cités:
**JP-A- S5 889 875    US-A- 5 552 373**
**US-B1- 6 541 789**

• **None**

EP 3 053 202 B1

**Description**

La présente invention concerne un procédé de fabrication d'une jonction Josephson. L'invention se rapporte aussi à une jonction Josephson.

Les composants supraconducteurs sont utilisés dans de multiples applications dont la détermination des susceptibilités magnétiques de minuscules échantillons sur une large plage de température, la détection de la résonance nucléaire magnétique et quadripolaire, la mesure de la température à l'aide de mesures de bruit (également appelée thermométrie de bruit), le biomagnétisme, la géophysique, le magnétisme des roches ou le paléomagnétisme.

Pour cela, il est fait usage de l'effet Josephson. Par définition, l'effet Josephson se manifeste par l'apparition d'un courant, également appelé supracourant, entre deux matériaux supraconducteurs séparés par une couche formée d'un matériau isolant ou métallique non supraconducteur. L'ensemble des deux matériaux supraconducteurs et de la couche est appelé une « jonction Josephson ».

L'apparition de ce courant s'explique par la théorie macroscopique de la supraconductivité développée par John Bardeen, Leon Cooper et Robert Schrieffer. Selon cette théorie, en-dessous de la température de transition supraconductrice, au moins une partie des électrons libres dans le matériau supraconducteur sont liés entre eux, de manière à former des paires d'électrons dites « paires de Cooper ».

La supraconductivité est un phénomène quantique macroscopique induisant un ordre à l'échelle macroscopique, ce qui a trois conséquences principales : une conductivité électrique infinie d'un anneau supraconducteur justifiant l'existence d'un courant de paires de Cooper permanent, la quantification du flux magnétique à travers un anneau supraconducteur, résultant de l'application d'un champ magnétique et du courant induit dans l'anneau et l'effet Josephson parfois appelé effet tunnel Josephson. Pour expliquer ce dernier phénomène, considérons deux supraconducteurs séparés par une mince barrière isolante à travers laquelle les paires de Cooper peuvent passer par un effet tunnel quantique, en maintenant la cohérence de phase entre les deux supraconducteurs durant le processus. Josephson a montré que la différence $\delta$ entre les phases des fonctions d'onde des deux côtés de la jonction Josephson est en relation avec le supracourant I circulant à travers la barrière et à la tension V aux bornes de la jonction Josephson par les relations suivantes :

$$\begin{cases} \sin\delta = \dfrac{I}{I_c} \\[3mm] V = \dfrac{\Phi_0}{2\pi}\dfrac{\partial\delta}{\partial t} \end{cases}$$

Où :

- $I_c$ est le courant critique, qui est le supracourant maximal que peut supporter la jonction Josephson ; ce courant critique est lié à la transparence de la barrière et la densité de paire de Cooper dans la jonction Josephson, et
- $\Phi_0$ est le quantum de flux, qui est le rapport entre la constante de Planck et la charge d'une paire de Cooper.

Dans une jonction Josephson, le courant de paires de Cooper contribue au transport électronique, mais en parallèle, il existe classiquement le courant d'électrons célibataires (« quasiparticules ») associé à un terme dissipatif caractérisé par une résistance $R_n$. Il en résulte une équation différentielle de premier ordre en $\delta$, qui peut se résoudre analytiquement pour donner l'évolution temporelle en $\delta$, ce qui donne après une moyenne temporelle l'équation suivante:

$$\langle V \rangle = \frac{\Phi_0}{2\pi}\left\langle \frac{\partial\delta}{\partial t} \right\rangle = V_C\sqrt{I^2 - I_C^2}$$

Où $V_c = R_n I_c$ est la tension caractéristique de la jonction Josephson.

Il est souhaitable de proposer des agencements de composants supraconducteurs permettant de bénéficier de cette propriété comme des boucles supraconductrices comprenant un dispositif supraconducteur d'interférences quantiques, plus souvent désigné sous l'acronyme anglais SQUID, qui renvoie à « Superconducting Quantum Interference Device ». Un tel SQUID est une boucle supraconductrice munie d'une (resp. deux) jonction(s) Josephson fonctionnant avec un courant radiofréquence (resp. un courant continu). Il convient d'obtenir que l'épaisseur de la boucle supraconductrice d'un circuit supraconducteur soit élevée, pour obtenir une inductance faible tout en ayant une épaisseur de jonction Josephson fine pour que la résistance normale soit forte.

Il est ainsi connu de l'état de la technique de réaliser des circuits supraconducteurs relativement complexes en deux dimensions en réalisant la barrière de la jonction Josephson par une irradiation localisée d'ions oxygène ou fluor.

Une faible dose d'irradiation permet d'obtenir une jonction Josephson pouvant fonctionner à une température de l'ordre de 70 K (Kelvins), mais présentant une résistance normale faible (quelques dixièmes de Ohm). Une telle résistance est généralement considérée comme trop faible.

Une forte dose d'irradiation ou une augmentation de l'épaisseur de la barrière permet d'augmenter la résistance de la jonction Josephson. Toutefois, cela impose un fonctionnement à des températures plus basses, par exemple entre 30 et 40 K, ce qui est contraignant.

Des exemples des circuits de type Josephson se trouvent dans les brevets JP58089875, US5552373 et US6541789.

Il existe donc un besoin pour un procédé de fabrication permettant d'obtenir une jonction Josephson fonctionnant à une résistance normale importante à une température relativement élevée. A cet effet, l'invention propose un procédé de fabrication d'une jonction Josephson comprenant :

- une étape de fourniture d'un substrat, s'étendant le long d'une première direction dite direction longitudinale,
- une étape de dépôt d'une couche supraconductrice sur le substrat de sorte que cette couche s'étende depuis le substrat dans une deuxième direction dite direction transversale, perpendiculaire à la direction longitudinale, et
- une étape d'irradiation d'ions dans une zone centrale de la couche définie dans la direction longitudinale, le procédé étant caractérisé en ce que le procédé comporte, préalablement à l'étape d'irradiation :

    - une étape d'enlèvement d'une partie de la zone centrale de la couche supraconductrice de manière à délimiter un ensemble de zones de la couche supraconductrice alignées dans la direction longitudinale comportant la zone centrale et deux zones latérales, la zone centrale étant disposée entre les deux zones latérales et présentant une dimension dans la direction transversale inférieure à la dimension de chaque zone latérale dans cette même direction transversale.

Suivant des modes de réalisation particuliers, le procédé comprend une ou plusieurs des caractéristiques suivantes, prise(s) isolément ou suivant toutes les combinaisons techniquement possibles :

- l'étape d'enlèvement est mise en œuvre par réalisation d'une lithogravure dans la couche supraconductrice ;
- la couche supraconductrice est formée d'au moins une couche supérieure et d'une couche inférieure en contact avec le substrat, chaque couche supérieure et la couche inférieure étant empilées selon la direction transversale, et chacune réalisée dans un matériau supraconducteur distinct, l'étape d'enlèvement étant mise en œuvre de manière à conserver sensiblement la couche inférieure dans la zone centrale ;
- l'étape d'irradiation comprend une pluralité de sous-étapes d'irradiation, chaque sous-étape d'irradiation étant mise en œuvre à une énergie distincte de manière à obtenir une succession de zones isolantes dans la zone centrale le long de la direction transversale ;

- l'étape d'enlèvement et l'étape d'irradiation sont mises en œuvre en utilisant un même masque de lithogravure ;

En outre, l'invention se rapporte aussi à un procédé de fabrication d'une jonction Josephson comprenant :

- une étape de fourniture d'un substrat, s'étendant le long d'une première direction dite direction longitudinale,
- une étape de dépôt d'une couche supraconductrice sur le substrat de sorte que cette couche s'étende depuis le substrat dans une deuxième direction dite direction transversale, perpendiculaire à la direction longitudinale, et
- une étape d'irradiation d'ions dans une zone centrale de la couche définie dans la direction longitudinale, le procédé étant caractérisé en ce que le procédé comporte une étape d'irradiation d'ions dans la zone centrale de la couche supraconductrice de manière à former deux zones alignées selon la direction transversale, l'une des deux zones en un matériau isolant et l'autre zone en un matériau conducteur, et de manière à délimiter un ensemble de zones de la couche supraconductrice alignées dans la direction longitudinale comportant la zone centrale et deux zones latérales, la zone centrale étant disposée entre les deux zones latérales, la zone en matériau conducteur de la zone centrale présentant une dimension dans la direction transversale inférieure à la dimension de chaque zone latérale dans cette même direction transversale.

En outre, l'invention se rapporte aussi à une jonction Josephson comprenant :

- un substrat s'étendant le long d'une première direction dite direction longitudinale,
- une couche supraconductrice disposée sur le substrat, s'étendant depuis le substrat dans une deuxième direction dite direction transversale, et comportant un ensemble de zones alignées dans la direction longitudinale, comprenant :

    ◦ une première zone latérale supraconductrice formée d'au moins un matériau supraconducteur et s'étendant selon la direction transversale,
    ◦ une deuxième zone latérale supraconductrice formée d'au moins un matériau supraconducteur et s'étendant selon la direction transversale, et
    ◦ une zone centrale formant une barrière disposée entre la première zone latérale supraconductrice et la deuxième zone latérale supraconductrice dans la direction longitudinale, la zone centrale présentant une dimension dans la direction transversale inférieure à la dimension de chaque zone latérale dans cette même direction transversale.

Suivant des modes de réalisation particuliers, la jonction comprend une ou plusieurs des caractéristiques suivantes, prise(s) isolément ou suivant toutes les combinaisons techniquement possibles :

- la zone centrale présente une dimension dans la direction transversale inférieure à 100 nm.

En outre, l'invention se rapporte aussi à une jonction Josephson comprenant :

- un substrat s'étendant le long d'une première direction dite direction longitudinale,
- une couche supraconductrice disposée sur le substrat, s'étendant depuis le substrat dans une deuxième direction dite direction transversale, et comportant un ensemble de zones alignées dans la direction longitudinale, comprenant :

    ◦ une première zone latérale supraconductrice formée d'au moins un matériau supraconducteur et s'étendant selon la direction transversale,
    ◦ une deuxième zone latérale supraconductrice formée d'au moins un matériau supraconducteur et s'étendant selon la direction transversale, et

une zone centrale formant une barrière disposée entre la première zone latérale supraconductrice et la deuxième zone latérale supraconductrice dans la direction longitudinale, la zone centrale comportant deux zones alignées selon la direction transversale, l'une des deux zones en un matériau isolant et l'autre zone en un matériau non supraconducteur, la zone en matériau non supraconducteur de la zone centrale présentant une dimension dans la direction transversale inférieure à la dimension de chaque zone latérale dans cette même direction transversale et permettant le transport électronique entre les deux zones latérales.

D'autres caractéristiques et avantages de l'invention apparaîtront à la lecture de la description détaillée qui suit de modes de réalisation de l'invention, donnée à titre d'exemple uniquement et en références aux dessins qui sont :

- figure 1, une vue schématique en coupe d'une jonction Josephson selon un premier mode de réalisation l'invention,
- figure 2, un organigramme représentant les étapes d'un exemple de procédé de fabrication d'une jonction Josephson selon l'invention,

- figure 3, une vue schématique en coupe de la jonction obtenue à l'issue de la mise en œuvre du procédé selon la figure 2,
- figure 4, un schéma d'un exemple de dispositif de fabrication d'une jonction Josephson selon l'invention, et
- figure 5, une vue schématique en coupe d'une jonction Josephson selon un deuxième mode de réalisation de l'invention.

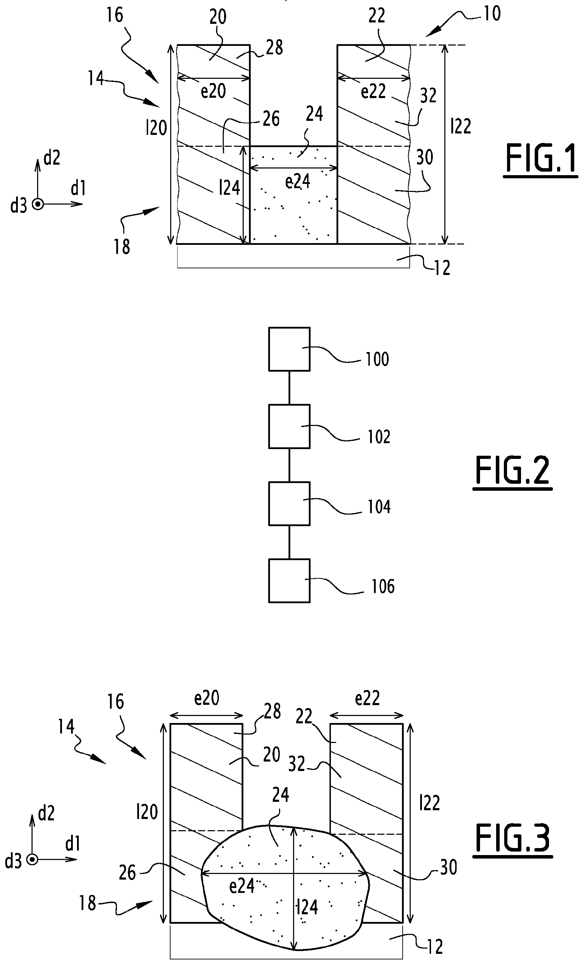

Une jonction Josephson 10 est représentée sur la figure 1.

La jonction Josephson 10 comporte un substrat 12 s'étendant le long d'une première direction dite direction longitudinale d1 et une couche supraconductrice 14 disposée sur le substrat 12. La direction longitudinale d1 est définie par la direction de transport du courant électronique dans la jonction Josephson 10 en fonctionnement.

Le substrat 12 est formé d'un matériau compatible avec le matériau supraconducteur de la couche supraconductrice 14. Les matériaux du substrat 12 sont en général choisis pour leurs propriétés structurales (paramètre de maille), chimiques (faible réactivité par rapport au supraconducteur) et électromagnétiques (constante diélectrique en fonction des applications, mais en général à faible pertes). A titre d'exemple, le matériau formant le substrat 12 est du $SrTiO_3$, du $LaAlO_3$, du $MgO$, du $Al_2O_3$ ou du $NdGaO_3$. La couche supraconductrice 14 est formée d'une couche supérieure 16 et d'une couche inférieure 18 en contact avec le substrat 12. La couche supérieure 16 et la couche inférieure 18 sont empilées selon une deuxième direction dite direction transversale d2 perpendiculaire à la direction longitudinale d1.

De préférence, la couche supraconductrice 14 est suffisamment épaisse pour être considérée comme un film supraconducteur. Typiquement, un film supraconducteur en un matériau avec une hauteur de maille élémentaire donnée présente une épaisseur supérieure à trois fois la hauteur de maille élémentaire.

Dans l'exemple décrit, la couche supérieure 16 est dans un premier matériau supraconducteur S1 tandis que la couche inférieure 18 est dans un deuxième matériau supraconducteur S2 distinct du premier matériau S1. Selon une variante, les deux matériaux supraconducteurs S1 et S2 sont identiques.

De préférence, les matériaux supraconducteurs S1 et S2 sont des matériaux supraconducteurs dits « à haute température critique », c'est-à-dire des supraconducteurs dont la température critique est supérieure à 30K ou 40 K selon les définitions couramment acceptées. A titre d'exemple, les matériaux supraconducteurs S1 et S2 sont des oxydes mixtes de baryum de cuivre et d'yttrium (formule chimique YBaCuO ou YBCO), des oxydes mixtes de baryum de cuivre et de néodyme (formule chimique NdBaCuO ou NdBCO) ou des oxydes mixtes de baryum de cuivre et de dysprosium (formule chimique DyBaCuO ou DyBCO). De préférence, le supraconducteur est non métallique, et en particulier du type céramique à base d'oxyde de cuivre (ReBaCuO, où Re représente un élément chimique du type terre rare).

En variante, la couche supraconductrice 14 comporte une pluralité de couches supérieures réalisées dans des matériaux supraconducteurs distincts au lieu d'une seule couche supérieure 16.

La couche supraconductrice 14 comprend une première zone latérale 20 supraconductrice, une deuxième zone latérale 22 supraconductrice et une zone centrale 24 formant barrière.

La première zone latérale 20 supraconductrice comporte une partie inférieure 26 formée dans le deuxième matériau supraconducteur S2 et une partie supérieure 28 formée dans le premier matériau supraconducteur S1. La séparation entre la partie inférieure 26 et la partie supérieure 28 est matérialisée sur la figure 1 par des traits en pointillé. La première zone latérale 20 s'étend depuis le substrat 12 selon la direction transversale d2.

La première zone latérale 20 présente une dimension e20 le long de la direction longitudinale d1.

La première zone latérale 20 présente une dimension l20 le long de la direction transversale d2 comprise, de préférence, entre 300 nm et 500 nm.

La première zone latérale 20 présente une dimension le long d'une troisième direction d3 (perpendiculaire à la direction longitudinale d1 et perpendiculaire à la direction transversale d2) comprise, de préférence, entre 0,2 micromètre ($\mu$m) et 5 $\mu$m. Avantageusement, la première zone latérale 20 présente une dimension de 1 $\mu$m le long de la troisième direction d3. Il est à noter que le substrat 12 s'étend également le long de la troisième direction d3.

La deuxième zone latérale 22 supraconductrice comporte une partie inférieure 30 formée dans le deuxième matériau supraconducteur S2 et une partie supérieure 32 formée dans le premier matériau supraconducteur S1. La séparation entre la partie inférieure 30 et la partie supérieure 32 est matérialisée sur la figure 1 par des traits en pointillé. La deuxième zone latérale 22 s'étend depuis le substrat 12 selon la direction transversale d2.

La deuxième zone latérale 22 présente une dimension e22 le long de la direction longitudinale d1.

La deuxième zone latérale 22 présente une dimension l22 le long de la direction transversale d2 comprise, de préférence, entre 300 nm et 500 nm. La dimension l22 le long de la direction transversale d2 est généralement égale à la dimension l20 le long de la direction transversale d2 de la première zone latérale 20, en particulier lorsque la méthode de croissance du supraconducteur utilisée pour obtenir la couche supraconductrice 14 produit un film mince suffisamment homogène.

La deuxième zone latérale 22 présente une dimension le long de la troisième direction d3 comprise, de préférence, entre 0,2 $\mu$m et 5 $\mu$m. Avantageusement, la deuxième zone latérale 22 présente une dimension de 1 $\mu$m le long de la troisième direction d3.

Selon l'exemple de la figure 1, la deuxième zone latérale 22 présente sensiblement les mêmes dimensions que la première zone latérale 20.

La zone centrale 24 est disposée entre la première zone latérale 20 supraconductrice et la deuxième zone latérale 22 supraconductrice dans la direction longitudinale d1.

La zone centrale 24 est formée dans un matériau dont les propriétés supraconductrices sont atténuées par rapport aux matériaux supraconducteurs de la première zone latérale 20 et de la deuxième zone latérale 22. A titre d'exemple, le matériau de la zone centrale 24 présente une température critique inférieure à celle des matériaux supraconducteurs de la première zone latérale 20 et de la deuxième zone latérale 22. L'objectif ainsi atteint est de rendre la zone centrale 24 la plus isolante possible pour les deux zones latérales 20, 22, ce qui optimise l'effet Josephson.

En variante, la zone centrale 24 est formée dans un matériau non supraconducteur.

La zone centrale 24 présente une dimension e24 le long de la direction longitudinale d1 permettant l'existence d'un effet Josephson entre les deux zones latérales 20, 22. Ainsi, la dimension e24 le long de la direction longitudinale d1 de la zone centrale 24 dépend du matériau de la zone centrale 24, et est de préférence inférieure à 100 nm, par exemple 20 nm, 40 nm ou 80 nm, pour de l'YBCO irradié aux ions oxygène.

La zone centrale 24 présente une dimension l24 le long de la direction transversale d2 inférieure à la dimension l20, l22 le long de la direction transversale d2 de chaque zone latérale 20, 22.

Avantageusement, la dimension l24 le long de la direction transversale d2 est choisie la plus petite dimension n'altérant pas les propriétés de transfert des électrons et des paires de Cooper dans la jonction Josephson 10.

Pour cela, par exemple, la dimension l24 de la zone centrale 24 le long de la direction transversale d2 est inférieure à 60% de la dimension l20, l22 de chaque zone latérale 20, 22 le long de la direction transversale d2, de préférence à 30%, préférentiellement à 10%.

Par exemple, la dimension l24 de la zone centrale 24 le long de la direction transversale d2 de la zone centrale 24 est comprise entre 50 nm et 100 nm.

La zone centrale 24 présente une dimension le long de la troisième direction d3 comprise, de préférence, entre 0,2 $\mu$m et 5 $\mu$m. De préférence, la zone centrale 24 présente une dimension de 1 $\mu$m le long de la troisième direction d3, c'est-à-dire une dimension égale aux dimensions de la première zone latérale 20 et de la deuxième zone latérale 22 le long de la troisième direction d3.

Le fonctionnement de la jonction Josephson 10 est similaire au fonctionnement d'une jonction Josephson traditionnelle. Il n'est donc pas décrit spécifiquement dans le cadre de cette description.

La jonction Josephson 10 de la figure 1 présente une zone centrale 24 formant barrière présentant une dimension I24 le long de la direction transversale d2 réduite. La section perpendiculaire aux lignes de courant parcourant la jonction Josephson est donc réduite. De ce fait, comme la valeur de la résistance normale de la jonction Josephson 10 est inversement proportionnelle à la section perpendiculaire aux lignes de courant, la valeur de la résistance normale est augmentée.

Cette augmentation de la résistance normale est obtenue sans modifier la température de fonctionnement des matériaux supraconducteurs S1, S2 des zones latérales 20, 22. De ce fait, la jonction Josephson 10 de la figure 1 est propre à fonctionner à des températures comprises entre 40 K et 80 K.

En outre, une telle jonction Josephson est de fabrication aisée ainsi que l'illustre le procédé de fabrication décrit en référence à l'organigramme de la figure 2 qui présente un exemple de mise en œuvre d'un procédé de fabrication d'une jonction Josephson 10 selon l'invention.

Le procédé de fabrication d'une jonction Josephson 10 comprend une étape 100 de fourniture du substrat 12, s'étendant le long d'une première direction dite direction longitudinale d1.

Le procédé comporte ensuite une étape 102 de dépôt d'une couche supraconductrice 14 sur le substrat 12 permettant d'obtenir un premier ensemble.

L'étape de dépôt 102 est, par exemple, mise en œuvre par une technique connue en soi de dépôt en phase vapeur chimique (souvent appelée CVD pour Chemical Vapor Déposition) ou physique en phase vapeur (souvent appelée PVD pour Physical Vapor Déposition). A titre d'exemple, l'étape de dépôt 102 est mise en œuvre par pulvérisation cathodique, par co-évaporation ou par ablation à l'aide d'une source laser puisée.

Le procédé comporte ensuite une étape de délinéation générale du premier ensemble, définissant l'extension du premier ensemble le long de la troisième direction d3, qui ne sera pas décrite car, elle est connue de l'homme de l'art

Le procédé comprend alors une étape d'enlèvement 104 d'une partie de la zone centrale 24 de la couche supraconductrice 14 de manière à délimiter un ensemble de zones de la couche supraconductrice 14 dans la direction longitudinale d1 comportant la zone centrale 24 et les deux zones latérales 20, 22 telles que la zone centrale 24 est disposée entre les deux zones latérales 20, 22 et présente une dimension I24 le long de la direction transversale d2 inférieure à la dimension I20, I22 le long de la direction transversale d2 de chaque zone latérale 20, 22.

Selon l'exemple illustré, l'étape d'enlèvement 104 est mise en œuvre par réalisation d'une lithogravure dans la couche supraconductrice 14. Dans ce cas, il est fait usage d'un masque de lithogravure sur lequel est envoyé un faisceau d'ions, ayant une énergie usuellement inférieure au keV (kilo électron-volt), conduisant à l'érosion du matériau supraconducteur S1 de la couche supérieure 16. Le masque de lithographie est, par exemple, formé dans un matériau polymère. Toute autre méthode d'enlèvement de matière peut être envisagée. A titre d'exemple, une gravure chimique ou une gravure par plasma peuvent être utilisées.

L'étape d'enlèvement 104 est mise en œuvre de manière à conserver au moins la couche inférieure 18 dans la zone centrale 24.

Par exemple, l'étape d'enlèvement 104 est stoppée lorsqu'il est détecté un changement du matériau supraconducteur dans lequel la lithogravure est mise en œuvre. Plus précisément, dans le cas de l'exemple présenté, lorsqu'il est détecté la présence du deuxième matériau supraconducteur S2.

Une telle détection est, à titre d'exemple, mise en œuvre par application d'une technique de spectrométrie de masse à ionisation secondaire. La spectrométrie de masse à ionisation secondaire est un procédé d'analyse de surface connu sous l'acronyme anglais de SIMS renvoyant à « Secondary Ion Mass Spectrometry ». Selon ce procédé, la surface de l'échantillon à analyser est bombardée par un faisceau d'ions, ce qui pulvérise et ionise une partie de la matière de la surface. Ces ions secondaires sont alors accélérés vers un spectromètre de masse qui permettra de mesurer la composition élémentaire, isotopique ou moléculaire de la surface de l'échantillon.

Le procédé comprend ensuite une étape 106 d'irradiation d'ions dans la zone centrale 24 de la couche définie dans la direction longitudinale d1.

A cette étape d'irradiation 106, il est fait, par exemple, usage du même masque de lithogravure que le masque utilisé à l'étape d'enlèvement 104. Cela permet d'irradier la zone centrale 24 qui a subi l'enlèvement avec un bon alignement (le masque n'est pas déplacé entre l'étape d'enlèvement 104 et l'étape d'irradiation 106).

L'irradiation se fait par bombardement d'ions à une énergie d'environ 100 keV pour les ions s'implantant dans le matériau supraconducteur S2 de la couche inférieure 18.

En outre, les ions irradiés à l'étape d'irradiation 106 sont des ions choisis pour s'implanter dans un matériau supraconducteur de manière à abaisser sa température critique. A titre d'exemple, les ions irradiés sont des ions oxygène fluor ou argon.

Le procédé de fabrication permet d'obtenir la jonction Josephson 10 de la figure 3. La jonction Josephson 10 de la figure 3 présente une zone centrale 24 formant barrière présentant une dimension I24 réduite le long de la direction transversale d2. La section perpendiculaire aux lignes du courant destiné à parcourir la jonction Josephson est donc réduite. De ce fait, comme la valeur de la résistance normale de la jonction Josephson 10 est inversement proportionnelle à la section perpendiculaire aux lignes de courant, la valeur de la résistance normale est augmentée.

Cette augmentation de la résistance normale est obtenue sans augmenter la dimension e24 le long de la direction longitudinale d1 de la zone centrale 24. De ce fait, la jonction Josephson 10 de la figure 3 est propre à fonctionner à des températures comprises entre 40K et 80K.

De plus, le procédé permet d'obtenir des parties de la première zone latérale 20 et de la deuxième zone latérale 24 non affectées par l'irradiation d'ions. Des simulations ont, en effet, montré une localisation préférentielle très nette des défauts induits par l'irradiation d'un faisceau d'ions sur la partie de la couche supraconductrice qui se trouve en regard du faisceau d'ions.

En l'occurrence, les parties non modifiées par l'introduction de défaut sont les parties supérieures 28, 32 de la première zone latérale 20 et de la deuxième zone latérale 24. Ainsi, le supracourant généré en fonctionnement de la jonction Josephson 10 accède à la zone centrale 24 en passant par les parties supérieures 28, 32. Le comportement de la jonction Josephson 10 est, de ce fait, plus proche du comportement théorique attendu que dans le cas d'une jonction Josephson obtenue par mise en œuvre d'un procédé de fabrication selon l'état de la technique.

Il est à noter que la jonction Josephson 10 de la figure 3 présente un effet dit de « poire » au niveau de la zone centrale 24, c'est-à-dire que certaines portions des zones latérales 20, 22 sont dégradées par l'irradiations d'ions. Du fait de cet effet de « poire », la dimension de la zone dégradée est supérieure à la dimension e24 le long de la direction longitudinale d1 de la zone centrale 24 et est de l'ordre de 100 nm. Toutefois, en pratique, comme le courant dans la jonction Josephson contourne les parties dégradées avant de passer par la zone centrale 24, la dimension effective le long de la direction longitudinale d1 de la zone centrale 24 vue par le courant est égale à la dimension e24 le long de la direction longitudinale d1 de la jonction Josephson 10 représentée à la figure 1.

Une application d'une telle jonction Josephson 10 concerne notamment la réalisation d'un SQUID présentant une meilleure sensibilité au champ magnétique. Cela est obtenu à l'aide d'une inductance de boucle relativement faible (résultant d'une section de la couche supraconductrice perpendiculaire à la direction longitudinale d1 élevée) et d'une résistance normale plus élevée (du fait de la dimension l24 le long de la direction longitudinale d2 réduite de la zone centrale 24). Une telle boucle peut être utilisée, par exemple, dans l'architecture des éléments (souvent désignés sous le terme anglais de « front-ends ») raccordés à l'antenne sur les dispositifs destinés à la guerre électronique, dans le domaine des communications, dans le domaine des RADAR ou pour le traitement du signal numérique ou analogique.

Selon une variante, les ions irradiés sont des ions différents de l'oxygène comme le fluor ou l'argon.

Selon encore une autre variante, l'étape 106 d'irradiation d'ions comprend une pluralité de sous-étapes d'irradiation, chaque sous-étape d'irradiation étant mise en œuvre à une énergie distincte de celles des autres sous-étapes de manière à obtenir une bonne homogénéité de la zone centrale 24 le long de la deuxième direction d2.

Selon une autre variante, l'étape 106 d'irradiation d'ions comprend une pluralité de sous-étapes d'irradiation, chaque sous-étape d'irradiation étant mise en œuvre avec des ions distincts de manière à obtenir une bonne homogénéité de la zone centrale 24 le long de la deuxième direction d2.

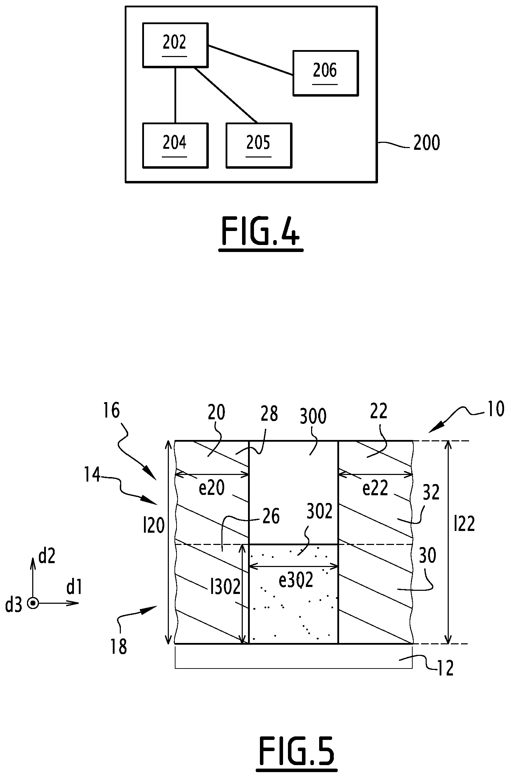

Le procédé est mis en œuvre par un dispositif 200 de fabrication d'une jonction Josephson tel que représenté à la figure 4. Le dispositif 200 comprend une unité de dépôt 202, une unité de lithographie électronique 204, une unité de gravure 205 et une unité d'irradiation d'ions 206.

L'unité de dépôt 202 est propre à déposer la couche supraconductrice 14 sur le substrat 12.

L'unité de lithographie électronique 204 est propre à transférer le motif d'un masque de lithogravure donné sur la couche servant de masque de gravure.

L'unité de gravure 205 est propre à enlever une partie de la zone centrale 24 de la couche supraconductrice 14 de manière à délimiter un ensemble de zones de la couche supraconductrice 14 dans la direction longitudinale d1 présentant la zone centrale 24 et les deux zones latérales 22, 24, pour la mise en œuvre de l'étape d'enlèvement 104.

L'unité d'irradiations d'ions 206 est propre à mettre en œuvre l'étape 106 d'irradiation d'ions. L'unité d'irradiations d'ions 206 est souvent désignée sous le terme d'« implanteur »

Selon un mode de réalisation particulier, les unités de lithographie électronique 204, de gravure 205 et d'irradiations d'ions 206 sont confondues.

La figure 5 illustre un deuxième mode de réalisation pour la jonction Josephson 10. Les éléments identiques au premier mode de réalisation ne sont pas répétés. Seules les différences sont mises en évidence.

La zone centrale 24 comporte, en outre, une zone isolante 300 et une zone non supraconductrice 302 superposées le long de la direction d2.

La zone non supraconductrice 302 de la zone centrale 24 présente une dimension e302 le long de la direction longitudinale d1 permettant l'existence d'un effet Josephson entre les deux zones latérales 20, 22. Ainsi, la dimension e302 le long de la direction longitudinale d1 de la zone centrale 24 est de préférence inférieure à 100 nm, par exemple 20 nm, 40 nm ou 80 nm.

La zone non supraconductrice 302 de la zone centrale 24 présente une dimension l302 le long de la direction transversale d2 inférieure à la dimension l20, l22 le long de la direction transversale d2 de chaque zone latérale 20, 22. Avantageusement, la dimension l302 le long de la direction transversale d2 est choisie la plus petite dimension n'altérant pas les propriétés de transfert des électrons et des paires de Cooper dans la jonction Josephson 10.

Pour cela, par exemple, la dimension l302 de

la zone non supraconductrice 302 de la zone centrale 24 le long de la direction transversale d2 est inférieure à 60% de la dimension l20, l22 de chaque zone latérale 20, 22 le long de la direction transversale d2, de préférence à 30%, préférentiellement à 10%.

Par exemple, la dimension l302 le long de la direction transversale d2 de la zone non supraconductrice 302 de la zone centrale 24 est comprise entre 50 nm et 100 nm.

La zone isolante 300 est disposée entre la première zone latérale 20 supraconductrice et la deuxième zone latérale 22 supraconductrice dans la direction longitudinale d1. La zone isolante 300 est positionnée sur la zone centrale 24.

La zone isolante 300 est formée dans un matériau isolant.

De ce fait, les propriétés de la jonction Josephson 10 selon le premier mode de réalisation sont les mêmes que celles de la jonction Josephson 10 selon le deuxième mode de réalisation.

Toutefois, le procédé de fabrication proposé diffère en ce qu'au lieu de mettre en œuvre une étape 104 d'enlèvement de la zone centrale 24 de la couche supraconductrice 14, il est mis en œuvre une étape d'irradiation d'ions dans la zone centrale 24 de la couche supraconductrice 14 de manière à former deux zones 300, 302 alignées selon la direction transversale d2, une zone 300 étant en un matériau isolant et une zone 302 étant en un matériau conducteur. En outre, cette étape d'irradiation permet de délimiter dans la couche supraconductrice 14 les deux zones latérales 20, 22 et la zone centrale 24.

De préférence, les ions sont des ions dont l'un des éléments est de numéro atomique supérieur ou égal à 27. Avantageusement, l'élément est un métal de transition. Par exemple, l'élément est du cobalt.

**Revendications**

1. Procédé de fabrication d'une jonction Josephson (10) comprenant :

   - une étape (100) de fourniture d'un substrat (12), s'étendant le long d'une première direction dite direction longitudinale (d1),
   - une étape (102) de dépôt d'une couche supraconductrice (14) sur le substrat (12) de sorte que cette couche (14) s'étende depuis le substrat (12) dans une deuxième direction dite direction transversale (d2), perpendiculaire à la direction longitudinale (d1), et
   - une étape (106) d'irradiation d'ions dans une zone centrale (24) de la couche (14) définie dans la direction longitudinale (d1),
   le procédé étant **caractérisé en ce qu'**une des propriétés suivantes est vérifiée :

      - une première propriété selon laquelle le procédé comporte, préalablement à l'étape d'irradiation (106) une étape (104) d'enlèvement d'une partie de la zone centrale (24) de la couche supraconductrice (14) de manière à délimiter un ensemble de zones (20, 22, 24) de la couche supraconductrice (14) alignées dans la direction longitudinale (d1) comportant la zone centrale (24) et deux zones latérales (20, 22), la zone centrale (24) étant disposée entre les deux zones latérales (20, 22) et présentant une dimension (l24) dans la direction transversale (d2) inférieure à la dimension (l20, l22) de chaque zone latérale (20, 22) dans cette même direction transversale (d2), et
      - une deuxième propriété selon laquelle le procédé comporte une étape d'irradiation d'ions dans la zone centrale (24) de la couche supraconductrice (14) de manière à former deux zones (300, 302) alignées selon la direction transversale (d2), l'une (300) des deux zones (300, 302) en un matériau isolant et l'autre zone (302) en un matériau conducteur, et de manière à délimiter un ensemble de zones (20, 22, 24) de la couche supraconductrice (14) alignées dans la direction longitudinale (d1) comportant la zone centrale (24) et deux zones latérales (20, 22), la zone centrale (24) étant disposée entre les deux zones latérales (20, 22), la zone en matériau conducteur (302) de la zone centrale (24) présentant une dimension (l302) dans la direction transversale (d2) inférieure à la dimension (l20, l22) de chaque zone latérale (20, 22) dans cette même direction transversale (d2).

2. Procédé selon la revendication 1, dans lequel l'étape d'enlèvement (104) est mise en œuvre par réalisation d'une lithogravure dans la couche supraconductrice (14).

3. Procédé selon la revendication 1 ou 2, dans lequel la couche supraconductrice (14) est formée d'au moins une couche supérieure (16) et d'une couche inférieure (18) en contact avec le substrat (12), chaque couche supérieure (16) et la couche inférieure (18) étant empilées selon la direction transversale (d2), et chacune réalisée dans un matériau supraconducteur distinct, l'étape d'enlèvement (104) étant mise en œuvre de manière à conserver sensiblement la couche inférieure (18) dans la zone centrale (24).

4. Procédé selon l'une quelconque des revendications 1 à 3, dans lequel l'étape d'irradiation comprend une pluralité de sous-étapes d'irradiation, chaque sous-étape d'irradiation étant mise en œuvre à une énergie distincte de manière à obtenir une succession de zones isolantes dans la zone centrale (24) le long de la direction transversale (d2).

5. Procédé selon l'une quelconque des revendications 1 à 3, dans lequel l'étape d'enlèvement (104) et l'étape d'irradiation (106) sont mises en œuvre en utilisant un même masque de lithogravure.

6. Jonction Josephson (10) comprenant :

- un substrat (12) s'étendant le long d'une première direction dite direction longitudinale (d1),
- une couche supraconductrice (14) disposée sur le substrat (12), s'étendant depuis le substrat (12) dans une deuxième direction dite direction transversale (d2), et comportant un ensemble de zones (20, 22, 24) alignées dans la direction longitudinale (d1), comprenant :

◦ une première zone latérale (20) supraconductrice formée d'au moins un matériau supraconducteur et s'étendant selon la direction transversale (d2),
◦ une deuxième zone latérale (22) supraconductrice formée d'au moins un matériau supraconducteur et s'étendant selon la direction transversale (d2), et
◦ une zone centrale (24) vérifiant l'une des propriétés suivantes :

▪ une première propriété selon laquelle la zone centrale forme une barrière disposée entre la première zone latérale (20) supraconductrice et la deuxième zone latérale (22) supraconductrice dans la direction longitudinale (d1), la zone centrale (24) présentant une dimension (I24) dans la direction transversale (d2) inférieure à la dimension (I20, I22) de chaque zone latérale (20, 22) dans cette même direction transversale (d2), et
▪ une deuxième propriété selon laquelle la zone centrale (24) forme une barrière disposée entre la première zone latérale (20) supraconductrice et la deuxième zone latérale (22) supraconductrice dans la direction longitudinale (d1), la zone centrale (24) comportant deux zones (300, 302) alignées selon la direction transversale (d2), l'une (300) des deux zones (300, 302) en un matériau isolant et l'autre zone (302) en un matériau non supraconducteur, la zone en matériau non supraconducteur (302) de la zone centrale (24) présentant une dimension (I302) dans la direction transversale (d2) inférieure à la dimension (I20, I22) de chaque zone latérale (20, 22) dans cette même direction transversale (d2) et permettant le transport électronique entre les deux zones latérales (20, 22)..

7. Jonction Josephson selon la revendication 6, dans laquelle la zone centrale (24) présente une dimension (I24) dans la direction transversale (d2) inférieure à 100 nm


**Patentansprüche**

1. Verfahren zum Herstellen eines Josephson-Übergangs (10), welches aufweist:

- einen Schritt (100) des Bereitstellens eines Substrats (12), welches sich entlang einer ersten Richtung, welche Längsrichtung (d1) genannt wird, erstreckt,
- einen Schritt (102) des Abscheidens einer supraleitenden Schicht (14) auf dem Substrat (12), so dass sich diese Schicht (14) vom Substrat (12) in einer zweiten Richtung, welche Querrichtung (d2) genannt wird und senkrecht zur Längsrichtung (d1) ist, erstreckt, und
- einen Schritt (106) des Einstrahlens von Ionen in eine zentrale Zone (24) der Schicht (14), welche in der Längsrichtung (d1) definiert ist, wobei das Verfahren **dadurch gekennzeichnet ist, dass** eine der folgenden Eigenschaften erfüllt ist:

- eine erste Eigenschaft, gemäß welcher das Verfahren vor dem Schritt des Einstrahlens (106) einen Schritt (104) des Entfernens eines Teils der zentralen Zone (24) der supraleitenden Schicht (14) aufweist, um einen Satz von Zonen (20, 22, 24) der supraleitenden Schicht (14) zu begrenzen, welche in der Längsrichtung (d1) ausgerichtet sind und die zentrale Zone (24) und zwei laterale Zonen (20, 22) aufweisen, wobei die zentrale Zone (24) zwischen den beiden lateralen Zonen (20, 22) angeordnet ist und eine Abmessung (I24) in der Querrichtung (d2) hat, welche kleiner ist als die Abmessung (I20, I22) jeder lateralen Zone (20, 22) in dieser gleichen Querrichtung (d2), und
- eine zweite Eigenschaft, gemäß welcher das Verfahren einen Schritt des Einstrahlens von Ionen in die zentrale Zone (24) der supraleitenden Schicht (14) aufweist, um zwei Zonen (300, 302) zu bilden, welche entlang der Querrichtung (d2) ausgerichtet sind, wobei die eine (300) der beiden Zonen (300, 302) aus einem isolierenden Material ist und die andere Zone (302) aus einem leitenden Material ist, und um einen Satz von Zonen (20, 22, 24) der supraleitenden Schicht (14) zu begrenzen, welche in der Längsrichtung (d1) ausgerichtet sind und welche die zentrale Zone (24) und zwei laterale Zonen (20, 22) aufweisen, wobei die zentrale Zone (24) zwischen den beiden lateralen Zonen (20, 22) angeordnet ist, wobei die Zone aus leitendem Material (302) der zentralen Zone (24) eine Abmessung (l302) in der Querrichtung (d2) hat, welche kleiner ist als die Abmessung (l20, l22) jeder lateralen Zone (20, 22) in dieser gleichen Querrichtung (d2).

2. Verfahren gemäß Anspruch 1, wobei der Schritt des Entfernens (104) durch Durchführung einer Lithographie in der supraleitenden Schicht (14) durchgeführt wird.

3. Verfahren gemäß Anspruch 1 oder 2, wobei die supraleitende Schicht (14) aus zumindest einer oberen Schicht (16) und einer unteren Schicht (18) in Kontakt mit dem Substrat (12) gebildet ist, wobei jede obere Schicht (16) und die untere Schicht (18) entlang der Querrichtung (d2) gestapelt sind und jeweils aus einem unterschiedlichen supraleitenden Material hergestellt sind, wobei der Schritt des Entfernens (104) durchgeführt wird, um die untere Schicht (18) in der zentralen Zone (24) im Wesentlichen zu bewahren.

4. Verfahren gemäß irgendeinem der Ansprüche 1 bis 3, wobei der Schritt des Einstrahlens eine Mehrzahl von Unterschritten des Einstrahlens aufweist, wobei jeder Unterschritt des Einstrahlens mit einer unterschiedlichen Energie durchgeführt wird, um eine Folge von isolierenden Zonen in der zentralen Zone (24) entlang der Querrichtung (d2) zu erhalten.

5. Verfahren gemäß irgendeinem der Ansprüche 1 bis 3, wobei der Schritt des Entfernens (104) und der Schritt des Einstrahlens (106) unter Verwendung einer gleichen Lithographie-Maske durchgeführt werden.

6. Josephson-Übergang (10), welcher aufweist:

   - ein Substrat (12), welches sich entlang einer ersten Richtung, welche Längsrichtung (d1) genannt wird, erstreckt,
   - eine supraleitende Schicht (14), welche auf dem Substrat (12) angeordnet ist, sich vom Substrat (12) in einer zweiten Richtung, welche Querrichtung (d2) genannt wird, erstreckt und einen Satz von Zonen (20, 22, 24) aufweist, welche in der Längsrichtung (d1) ausgerichtet sind, aufweisend:

   o eine erste laterale supraleitende Zone (20), welche aus zumindest einem supraleitenden Material gebildet ist und sich entlang der Querrichtung erstreckt (d2),
   o eine zweite laterale supraleitende Zone (22), welche aus zumindest einem supraleitenden Material gebildet ist und sich entlang der Querrichtung (d2) erstreckt, und
   o eine zentrale Zone (24), welche eine der folgenden Eigenschaften erfüllt:

   ▪ eine erste Eigenschaft, gemäß welcher die zentrale Zone eine Barriere bildet, welche zwischen der ersten lateralen supraleitenden Zone (20) und der zweiten lateralen supraleitenden Zone (22) in der Längsrichtung (d1) angeordnet ist, wobei die zentrale Zone (24) eine Abmessung (l24) in der Querrichtung (d2) hat, welche kleiner ist als die Abmessung (l20, l22) jeder lateralen Zone (20, 22) in dieser gleichen Querrichtung (d2), und
   ▪ eine zweite Eigenschaft, gemäß welcher die zentrale Zone (24) eine Barriere bildet, welche zwischen der ersten lateralen supraleitenden Zone (20) und der zweiten lateralen supraleitenden Zone (22) in der Längsrichtung (d1) angeordnet ist, wobei die zentrale Zone (24) zwei Zonen (300, 302) aufweist, welche entlang der Querrichtung (d2) ausgerichtet sind, wobei die eine (300) der beiden Zonen (300, 302) aus einem isolierenden Material ist und die andere Zone (302) aus einem nicht-supraleitenden Material ist, wobei die Zone aus nicht-supraleitendem Material (302) der zentralen Zone (24) eine Abmessung (l302) in der Querrichtung (d2) hat, welche kleiner ist als die Abmessung (l20, l22) jeder lateralen Zone (20, 22) in dieser gleichen Querrichtung (d2), und den elektronischen Transport zwischen den beiden lateralen Zonen (20, 22) erlaubt.

7. Josephson-Übergang gemäß Anspruch 6, wobei die zentrale Zone (24) eine Abmessung (l24) in der Querrichtung (d2) hat, welche kleiner als 100 nm ist.

**Claims**

1. A process for manufacturing a Josephson junction (10) comprising:

- a step (100) for providing a substrate (12), extending along a first direction, a so-called longitudinal direction (d1),
- a step (102) for depositing a superconducting layer (14) on the substrate (12) so that this layer (14) extends from the substrate (12) in a second direction, a so-called transverse direction (d2), perpendicular to the longitudinal direction (d1), and
- a step (106) for irradiation of ions in a central area (24) of the layer (14) defined in the longitudinal direction (d1),

the process being **characterized in that** one of the following properties is fulfilled:

- a first property according to which the process includes, prior to the irradiation step (106) a step (104) for removing a portion of the central area (24) of the superconducting layer (14) so as to delimit a set of areas (20, 22, 24) of the superconducting layer (14) aligned in the longitudinal direction (d1) including the central area (24) and two lateral areas (20, 22), the central area (24) being positioned between both lateral areas (20, 22) and having a dimension (I24) in the transverse direction (d2) smaller than the dimension (I20, I22) of each lateral area (20, 22) in this same transverse direction (d2), and
- a second property according to which the process includes a step for irradiation of ions in the central area (24) of the superconducting layer (14) so as to form two areas (300, 302) aligned along the transverse direction (d2), one (300) of both areas (300, 302) being in an insulating material and the other area (302) in a conducting material, and so as to delimit a set of areas (20, 22, 24) of the superconducting layer (14) aligned in the longitudinal direction (d1) including the central area (24) and two lateral areas (20, 22), the central area (24) being positioned between both lateral areas (20, 22), the area in a conducting material (302) of the central area (24) having a dimension (I302) in the transverse direction (d2) smaller than the dimension (I20, I22) of each lateral area (20, 22) in this same transverse direction (d2).

2. The method according to claim 1, wherein the removal step (104) is applied by achieving lithographic etching in the superconducting layer (14).

3. The method according to claim 1 or 2, wherein the superconducting layer (14) is formed with at least one upper layer (16) and a lower layer (18) in contact with the substrate (12), each upper layer (16) and the lower layer (18) being stacked along the transverse direction (d2), and each made in a distinct superconducting material, the removal step (104) being applied so as to substantially retain the lower layer (18) in the central area (24).

4. The method according to any of claims 1 to 3, wherein the irradiation step comprises a plurality of irradiation sub-steps, each irradiation sub-step being applied at a distinct energy so as to obtain a succession of insulating areas in the central area (24) along the transverse direction (d2).

5. The method according to any of claims 1 to 3, wherein the removal step (104) and the irradiation step (106) are applied by using a same lithographic mask.

6. A Josephson junction (10) comprising:

- a substrate (12) extending along a first direction, a so-called longitudinal direction (d1),
- a superconducting layer (14) positioned on the substrate (12), extending from the substrate (12) in a second direction, a so-called transverse direction (d2), and including a set of areas (20, 22, 24) aligned in the longitudinal direction (d1), comprising:

  ○ a first superconducting lateral area (20) formed with at least one superconducting material and extending along the transverse direction (d2),
  ○ a second superconducting lateral area (22) formed with at least one superconducting material and extending along the transverse direction (d2), and
  ○ a central area (24) fulfilling one of the following properties:

    ▪ a first property according to which the central area (24) forms a barrier positioned between the first superconducting lateral area (20) and the second superconducting lateral area (22) in the longitudinal direction (d1), the central area (24) having a dimension (I24) in the transverse direction (d2) smaller than the dimension (I20, I22) of each lateral area (20, 22) in this same transverse direction (d2), and
    ▪ a second property according to which the central area (24) forms a barrier positioned between the first superconducting lateral area (20) and the second superconducting lateral area (22) in the longitudinal direction (d1), the central area (24) including two areas (300, 302) aligned along the transverse direction (d2), one (300) of both areas (300, 302) being in an insulating material and the other area (302) in a non-superconducting material, the area in a non-superconducting material (302) of the central area (24) having a dimension (l302) in the transverse direction (d2) smaller than the dimension (l20, l22) of each lateral area (20, 22) in this same transverse direction (d2) and allowing electron transport between both lateral areas (20, 22).

7. The Josephson junction according to claim 6, wherein the central area (24) has a dimension (l24) in the transverse direction (d2) of less than 100 nm

FIG.1

FIG.2

FIG.3

## FIG.4

## FIG.5

**EP 3 053 202 B1**